# EUROPEAN PATENT APPLICATION

(11) **EP 0 907 211 A1**
(43) Date of publication of application: **07.04.1999**
(21) Application number: 97402293.1
(22) Date of filing: 01.10.1997
(51) Int. Cl.: H01L 35/22, H01L 35/32, H01L 35/34

(54) **A peltier effect module and a method of manufacturing it**

(71) Applicant: IMRA EUROPE S.A., F-06560 Valbonne (FR)
(72) Inventor: Ancey, Pascal, 06130 Grasse (FR); Ishihara, Kunio, 06600 Antibes (FR); Fontaine, Jean-Pierre, 06600 Antibes (FR); Lauretti, Jean, 06110 Le Cannet (FR); Gschwind, Michel, 06130 Plascassier (FR)
(74) Representative: Leszczynski, André

(57) **Abstract**

The invention concerns a Peltier effect module comprising two semiconductor thermoelectric elements, preferably a P type element and an N type element, constituted by small blocks of semiconductor material.

The module is characterized by the fact that the two thermoelectric elements (1n, 2n) are stacked in alignment with each other.

The invention also concerns a method of simultaneous fabricating a plurality of such Peltier effect modules.

## Description

The present invention relates to a Peltier effect module and to a method of manufacturing it.

π-structure Peltier effect modules are already known comprising two semiconductor thermoelectric elements, one being of P type and the other of N type, made up of small blocks or stacks of small blocks of semiconductor material, disposed parallel to each other and united at one end by a conductive metal plate. The two thermoelectric elements are connected to a power supply via their ends remote from the conductive metal plate.

When an electric current flows through the module towards the conductive metal plate in one of the thermoelectric elements and away from it in the other thermoelectric element, a quantity of heat is consumed or produced at each junction between the conductive metal plate and each of the thermoelectric elements respectively, thereby giving rise to a flow of heat within each thermoelectric element.

The heat flows in the two thermoelectric elements are both in the same direction, which depends on the direction of current flow.

In other words, for a given direction of current flow, the conductive metal plate is heated and the opposite ends of the thermoelectric elements remote from the plate are cooled, while for current flowing in the opposite direction, the metal plate is cooled and the opposite ends of the thermoelectric elements remote from the plate are heated.

Such Peltier effect modules generally give satisfaction with respect to thermoelectric performance, in particular because the conductive metal plate which establishes the junction between the two thermoelectric elements is isolated from the remainder of the module, but they suffer from the drawback of being quite expensive to make because of the labor required for fabricating them.

In addition, when they are subjected to temperature cycles of large amplitude, they are subjected to large mechanical stresses, mainly because the metal plate expands, which stresses can, in the long run, crack them or even break them.

In FR-A-2 703 833, the Applicant company has already described a device comprising a succession of Peltier effect modules connected in series and each constituted by an N type semiconductor strip and a P type semiconductor strip, the two strips being formed by thermal diffusion as thin films on a substrate in line with each other.

Such modules are cheaper to make than π-modules, but the necessity for a substrate on which the semiconductor strips are formed makes them unsuitable in certain applications.

In addition, a vertical junction between the terminal faces of the two semiconductor strips is difficult to make and one has to add a strip performing the electrical junction over the ends of the semiconductor strips.

Whatever form it takes, the junction between the two semiconductor strips cannot be isolated from the remainder of the module, but remains in the vicinity of the substrate. The junction thus presents too much thermal inertia, which prevents it from responding rapidly to large temperature oscillations.

Confronted with this problem, proposals have already been made to eliminate the portion of substrate that is situated beneath the junction by using etching or micromachining techniques after the thin films have been formed. However that solution increases the cost and the complexity of fabricating the device.

In other words, such modules suffer from the fact that their thermoelectric modules are not constituted by blocks of semiconductor material, but by semiconductor strips that cannot be separated from the substrate on which they are formed.

In addition, the semiconductor strips are formed as thin films and are therefore of very small section, so they provide relatively high electrical resistance which is a drawback in the use of the device because of the Joule effect which opposes the cooling Peltier effect.

The present invention seeks to provide a Peltier effect module which solves the drawbacks of known modules.

The present invention provides a Peltier effect module comprising two semiconductor thermoelectric elements, preferably a P type element and an N type element, constituted by small blocks of semiconductor material, the module being characterized by the fact that the two thermoelectric elements are stacked in alignment with each other.

According to the invention, a small block of semiconductor material means a piece of material resulting from machining or sawing of a bigger block of material, or any other technique permitting to cut the bigger block of material.

It is prefered that the smallest dimension of a small block of material be greater than 100µm.

In other words, in the Peltier effect module of the invention, the two thermoelectric elements which are small blocks of semiconductor material are not disposed parallel and side by side, but are situated in line with each other, forming a bar which constitutes the Peltier effect module.

The two thermoelectric elements can be held in alignment with each other by adhesive or other bonding.

Thus, a module structure is obtained in which the junction between the two thermoelectric elements is isolated from the remainder of the module.

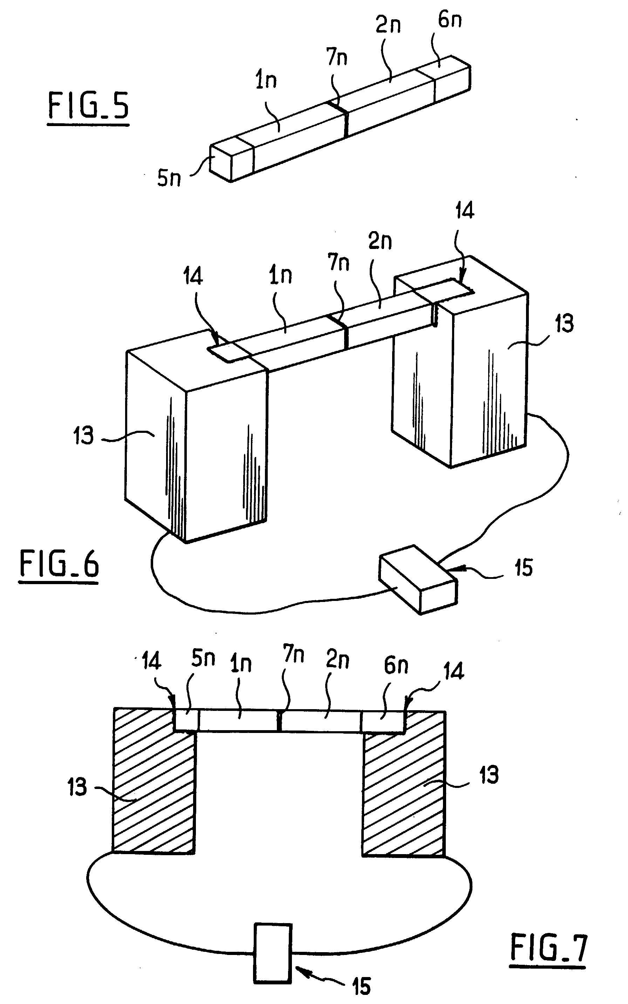

Tests performed by the Applicant company with a device of the kind shown in Figures 6 and 7, which are described below, have shown that quite unexpectedly, the Peltier effect module of the invention can endure temperature oscillations of large amplitude, i.e. of at least 10°C, at a frequency of Hertz order for a very long period of time without breaking or even cracking.

Thus, it appears that the bar structure of the Peltier effect module of the invention is stronger than the prior π-structure.

In addition, the structure of the module of the invention makes it possible to use different lenghts for the two semiconductor thermoelectric elements, in order to balance their thermoelectric properties, which was obviously not possible with the prior π-structure.

In a particular embodiment of the invention, each thermoelectric element includes a stud of electrically conductive material, e.g. copper at its end remote from the other thermoelectric element, the two studs being of different lengths.

It will be understood that each stud makes it possible to connect the Peltier effect module electrically to a power supply.

Also, the difference in length between the two studs makes it possible to identify the orientation of the module, i.e. to distinguish its P type element from its N type element.

In a particular embodiment, a material that is conductive, porous, and suitable for absorbing water, is interposed between the thermoelectric elements, e.g. for the purpose of absorbing water that condenses from the humidity of ambient air.

Such a material can be obtained by chemically etching a block of metal such as copper, or it may be a metal foam, e.g. a nickel foam of the type used in storage batteries.

The presence of such a foam between the two thermoelectric elements has the additional advantage that any deformation of the module resulting from temperature variations can be absorbed by the foam which then constitutes a resilient junction.

It is also possible for the Peltier effect module of the invention to receive parts for the purpose of improving its operation and its reliability.

In a first embodiment, the module is provided with at least one fin of a material that is a good conductor of heat extending in a plane perpendicular to its axis, in the vicinity of its junction.

The function of the fin is to increase the convective heat exchange area between the junction and ambient air.

Other fins can also be disposed on each element at a certain distance from the junction to dissipate the heat due to Joule effect that tends to accumulate in this region of each element.

In a second embodiment, a plate of a material that is a good conductor of heat, such as copper, is placed at the end of each element, extending as far as its end face providing the junction. If the plate is made of a material with high emissivity, it provides an increased area for radiant heat exchange with the outside, which is advantageous when a module of the invention is used as a heat flow meter, i.e. a device for metering radiant heat exchanges.

In a third embodiment, the junction and the ends of the two elements are covered with a sleeve of material that is a good conductor of heat, optionally by interposing insulation between the sleeve and the elements in order to avoid short-circuiting the junction if the material is also a good conductor of electricity.

In addition to increasing the area of heat exchange with the outside, the function of such a sleeve is to protect the junction which is liable to corrosion, particularly when the module is used to detect condensation of water on the sleeve.

A method of installing such sleeves collectively on a plurality of modules can consist in vapor deposition of a metal in a vacuum, after masking those portions of the modules other than their junction ends by means of two facing masks constituted by blocks provided with a plurality of parallel holes in which said modules are engaged via their ends remote from the junctions.

The present invention also provides a method of simultaneously fabricating a plurality of Peltier effect modules of the kind described above.

This method is characterized by the fact that it consists in assembling face-to-face two blocks of semiconductor material substantially in the form of rectangular parallelepipeds, preferably one block being of N type and the other being of P type, and in cutting up the resulting assembly perpendicularly to its assembly faces to form bars each constituted by a stack of two small blocks or elements, preferably an N type element and a P type element which are bonded together in line with each other.

The method of the invention has the advantage of providing a large number of Peltier effect modules simultaneously for a small number of operations.

In other words, the method of the invention makes it possible to obtain Peltier effect modules very cheaply.

According to the invention, the two blocks can be assembled together by adhesive or by other bonding.

Between the two blocks, it is possible to interpose a plate of foam material suitable for absorbing water.

Preferably, cutting is performed initially in a first series of mutually parallel planes, and then in a second series of mutually parallel planes that are perpendicular to the planes of the first series.

Bars are thus obtained that are rectangular or square in section.

In a preferred implementation, prior to performing the cutting, a plate of conductive material, e.g. copper, is stuck or otherwise bonded to the face of each block that is remote from its face that is to be bonded to the other block.

In a preferred variant, two plates of conductive material of different thicknesses are used so as to distinguish the P type thermoelectric element from the N type thermoelectric element in each of the bars that result from the cutting operations, or for the purpose of balancing the resistivities on either side of the junction in each bar.

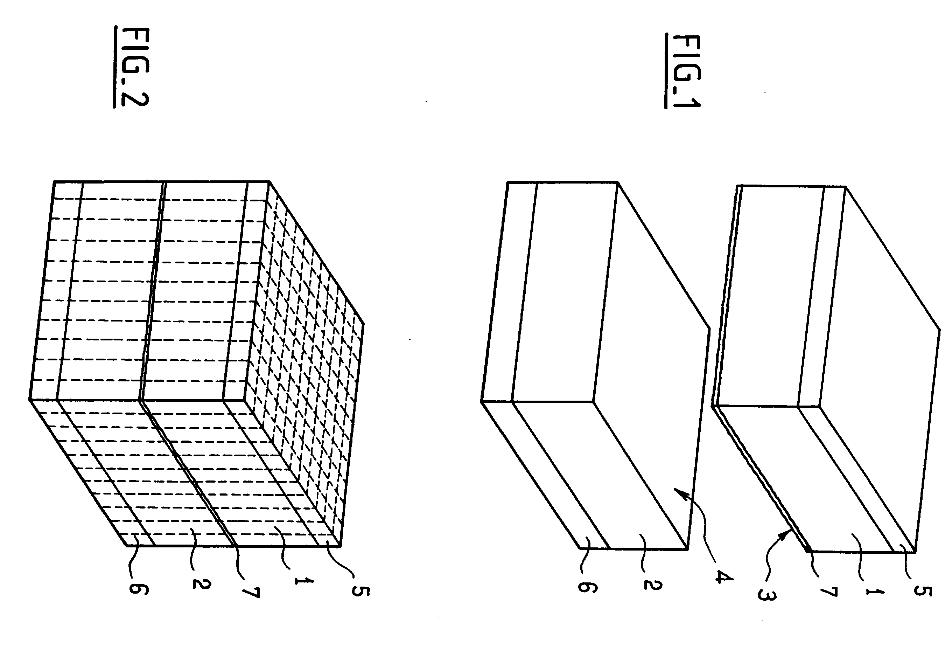

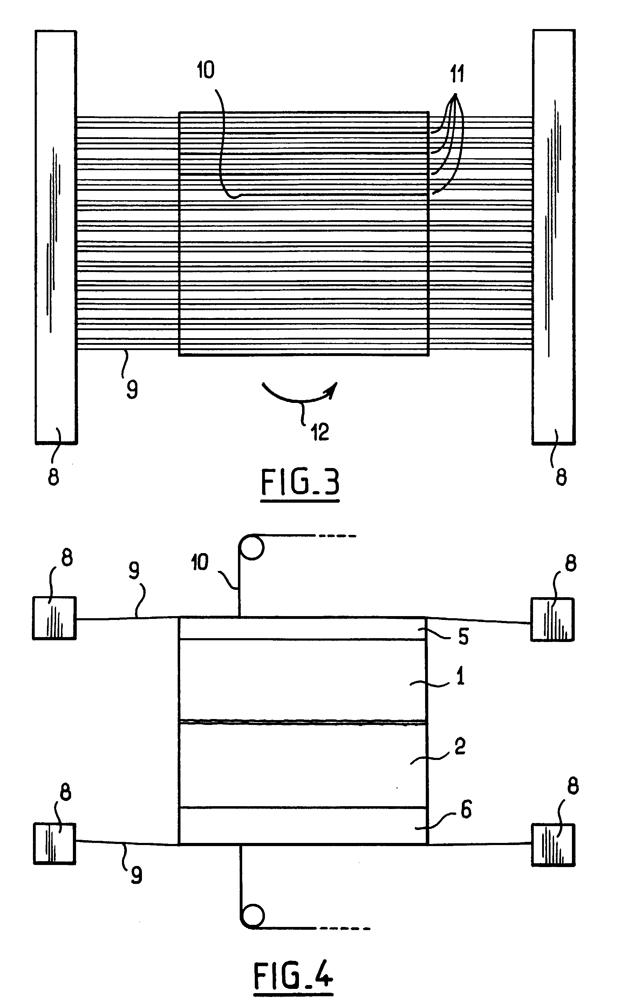

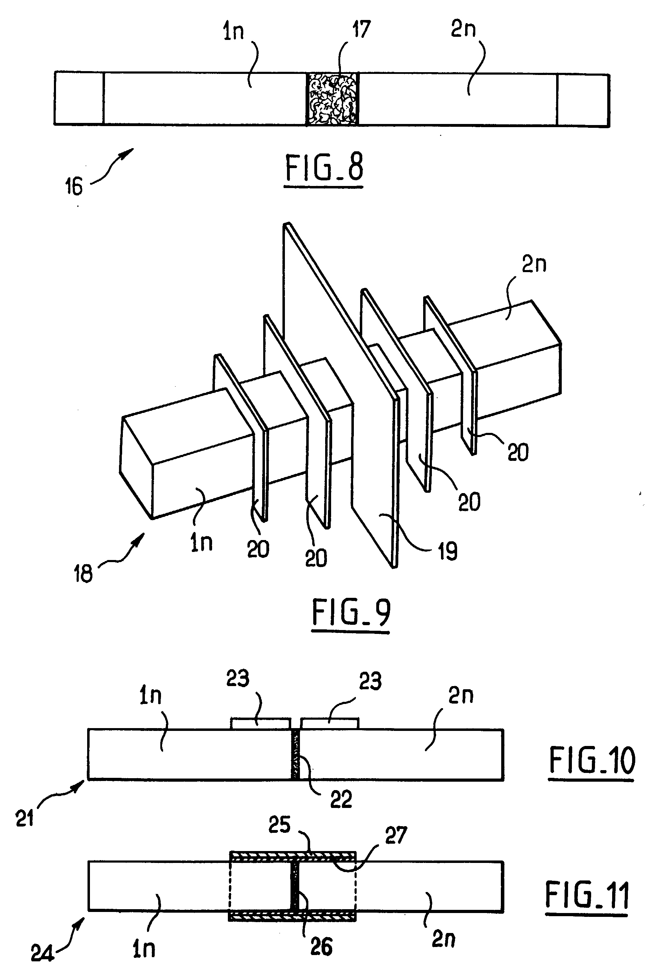

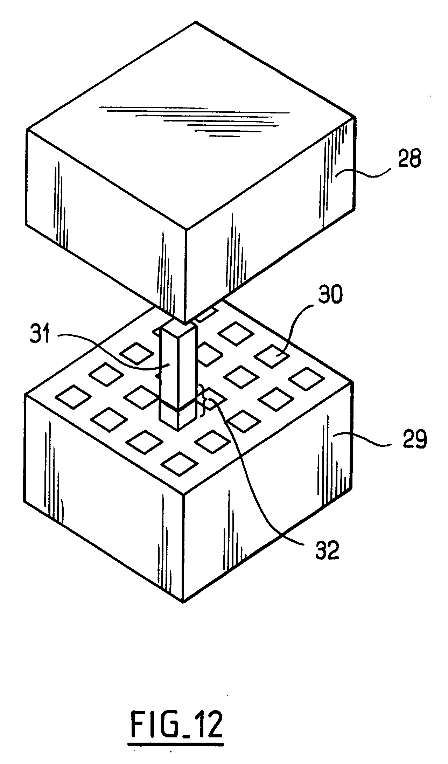

In order to make the invention easier to understand, there follows a description of various embodiments given as non-limiting examples, and with reference to the accompanying drawings, in which:
. Figure 1 is a perspective view of two semiconductor blocks prior to assembly;
. Figure 2 is a perspective view of the two blocks of Figure 1 after they have been assembled together;
. Figure 3 is a plan view of the two assembled-together blocks while cutting is being performed;
. Figure 4 is an elevation view of the two assembled-together blocks while cutting is being performed;
. Figure 5 is a perspective view of a module provided by the cutting;
. Figure 6 is a perspective view of a device making use of the Figure 5 module;
. Figure 7 is a longitudinal section of the Figure 6 device;
. Figure 8 is an elevation view of a module constituting an embodiment of the invention;
. Figure 9 is a perspective view of a module constituting a different embodiment of the invention;
. Figure 10 is a section view of a module constituting another embodiment of the invention;
. Figure 11 is a section view of a module constituting another embodiment of the invention; and
. Figure 12 is a perspective view of two masks suitable for obtaining modules as shown in Figure 11.

Figure 1 shows two rectangular parallelepiped blocks 1 and 2 of semiconductor material which may, for example, be constituted by sintered Bi₂Te₃, the block 1 being P-doped while the block 2 is N-doped.

The blocks 1 and 2 have large faces 3 and 4 of the same dimensions.

A nickel layer (not shown) is deposited on said faces 3,4.

The term "junction face" is used to designate the facing large faces of the blocks when they are in the position shown in Figure 1.

Opposite from its junction face, each block has a nickel layer (as on faces 3 and 4) and a plate 5 or 6 of conductive material, e.g. copper, bonded to said layer.

The nickel layers on the junction faces and opposite therefrom are intended to prevent impurities coming from bonding material or from copper to penetrate the semiconductor materials.

The nickel layers also provide a better electrical contact with material bonded thereto.

It will be observed that the copper plates 5 and 6 are of different thicknesses. The main function of this difference is to distinguish the blocks 1 and 2 and above all to identify, in each individual bar obtained from these two blocks, the P type thermoelectric element from the N type thermoelectric element, in a manner explained below.

The nickel layer on the junction face 3 of P type block 1 is covered in a layer of solder 7 to enable the two blocks 1 and 2 to be assembled together, as shown in Figure 2.

It should be observed that the copper plates 5 and 6 could be bonded to the blocks 1 and 2 after they have been assembled together.

In Figure 2, dashed lines show the various planes along which the resulting assembly is to be cut up in order to obtain individual modules of the invention, each constituting a bar.

In the example shown, cutting is performed on 10 x 10 planes to obtain 121 individual bars.

Figures 3 and 4 are highly diagrammatic, showing apparatus suitable for performing the cutting.

The apparatus comprises four supports 8 mounted on a frame (not shown).

Cables 9 are tensioned as a sheet between the top two supports 8 and between the bottom two supports 8, and they are grouped together in bunches of three.

Between two bunches of three cables, a gap is left through which a saw wire 10 can cut the assembly.

In the plan view of Figure 3, there can be seen four saw cuts 11, one of which is in the process of being made, with the saw moving to the left in the figure.

Once all of the cuts have been made parallel to the cables 9, the assembly is cut up into a plurality of mutually separate plates that are held side by side by the cables 9. The assembly is then repositioned between the cables 9 after being turned through 90° as shown by arrow 12.

It is then possible to perform cutting on planes perpendicular to the first cuts.

At the end of cutting, a plurality of bars are obtained each constituted by a stack of two small blocks of semiconductor thermoelectric elements 1n and 2n, one being of P type and the other of N type, the two elements being situated in line with each other and being joined together at one of their ends, and each element being provided at its end remote from the junction with a copper stud 5n, 6n as can be seen in Figure 5.

Such a bar can be used in a device such as that shown in Figure 6, which device comprises two supports 13, both of which conduct electricity and heat.

Each support 13 includes a notch 14 for receiving and bonding to one copper stud at the end of the bar. The notches 14 are so proportioned that they do not contact the semiconductor elements 1n and 2n.

The junction 7n between the two thermoelectric elements 1n and 2n is thus isolated from the remainder of the device.

Each support 13 is connected to a power supply 15 whose terminals are selected as a function of the orientation of the bar which can be identified because of the different lengths of the two copper studs 5n and 6n.

Such a device can be subjected to a square wave alternative current which generates large amplitude temperature oscillations at the junction 7n without the bar being damaged, and that constitutes one of the advantages of the bar of the invention.

It will be understood that the manufacturing method of the invention which makes it possible to obtain a large number of individual bars in a single operation is particularly cheap, thus constituting another major advantage of the invention.

Figure 8 shows a bar 16 of the invention which includes nickel foam 17 between its two thermoelectric elements 1n and 2n.

The foam 17 comes from a sheet of foam interposed between the semiconductor blocks and which is cut up at the same time as the elements are cut apart to obtain the bar directly.

The thickness of the sheet of foam used preferably lies in the range 0.1 mm to 1 mm.

The junctions between the foam 17 and the thermoelectric elements 1n and 2n are provided by a preferably non-corrosive material which is to be preferred over an SnPb solder which tends to corrode.

The bar obtained in this way is particularly suitable for use in detecting a risk of condensation, as already described by the Applicant company in its French patent application No. 93/02099, published under the No. 2 702 049.

In the embodiment of Figure 9, the bar 18 includes a copper fin 19 that is U-shaped, being placed over the junction connecting together the two thermoelectric elements 1n and 2n.

The function of the fin 19 is to increase the convective heat exchange area between ambient air and the junction.

Other fins 20 of the same shape but smaller than the fin 19 serve to dissipate the heat which accumulates in the thermoelectric elements after several temperature cycles have been imposed on the junction.

In the embodiment of Figure 10, on either side of the junction 22, the bar 21 has two copper plates 23 applied to the ends of its two thermoelectric elements 1n and 2n.

These plates 23 serve to increase the radiant heat exchange area between the junction 22 and its environment.

Since the plates 23 are separate from each other, they can be soldered directly on the thermoelectric elements.

In contrast, in the embodiment of Figure 11, the bar 24 has a copper sleeve 25 covering its junction 26 and the ends of both thermoelectric elements 1n and 2n.

The sleeve 25 which has the same function as the above-described plate 23 is electrically conductive, which is why a layer of insulating material 27 is provided between the thermoelectric elements and the sleeve, in order to avoid the sleeve short circuiting the junction 26.

The insulating material 27 and the sleeve 25 can be applied collectively on all of the bars obtained by cutting up the block in the manner described above.

To this end, it is possible to use the masks shown in Figure 12 each of which is constituted by a block 28 or 29 in the form of a parallelepiped pierced by holes 30 on parallel axes of section corresponding substantially to that of a bar 31.

When the bars are engaged both in the mask 29 and in the mask 28, only a height 32 of said bars remains exposed to the surrounding air on either side of their junctions.

This height 32 corresponds to the length of the sleeves that are to be made.

The entire assembly is then inserted in a vacuum enclosure for vapor deposition, firstly of an insulating material 27, and then of copper to make the sleeves 25.

This method has the advantage of being applied to all of the bars obtained by cutting up the blocks as described above.

Naturally the embodiments described above are not limiting in any way and could be modified in any desirable manner without thereby going beyond the ambit of the invention.

In particular, without going beyond the ambit of the invention, it is possible to make up modules comprising a single N type or P type semiconductor element together with a layer of solder or a copper stud.

## Claims

1. A Peltier effect module comprising two semiconductor thermoelectric elements, preferably a P type element and an N type element, constituted by small blocks of semiconductor material, the module being characterized by the fact that the two thermoelectric elements (1n, 2n) are stacked in alignment with each other.

2. A module according to claim 1, characterized by the fact that the smallest dimension of each small block of semiconductor element is greater than 100 µm.

3. A module according to claim 1 or 2, characterized by the fact that the two thermoelectric elements (1n, 2n) are held in mutual alignment by adhesive or by other bonding.

4. A module according to any one of claims 1 to 3, characterized in that each thermoelectric element (1n, 2n) includes a stud of electrically conductive material, e.g. copper (5n, 6n) at its end remote from the other thermoelectric element, the two studs being of different lengths.

5. A module according to any one of claims 1 to 4, characterized by the fact that it includes, interposed between the two thermoelectric elements (1n, 2n) a porous and conductive material (17) suitable for absorbing water.

6. A module according to claim 5, in which the porous material (17) is a block of metal such as copper that has been subjected to chemical etching.

7. A module according to claim 5, in which the porous material (17) is a metal foam, e.g. a nickel foam.

8. A module according to any one of claims 1 to 7, characterized by the fact that it includes at least one fin (19) of a material that is a good conductor of heat and extending in a plane perpendicular to its axis, at the level of its junction.

9. A module according to any one of claims 1 to 8, characterized by the fact that it includes at least one fin (20) at a distance from the junction to dissipate the heat due to Joule effect that tends to accumulate in this region of said element.

10. A module according to any one of claims 1 to 9, characterized by the fact that it includes a plate (23) of a material that is a good conductor of heat, such as copper, at the end of each element, and extending as far as its end face associated with the junction.

11. A module according to any one of claims 1 to 7, and 9, characterized by the fact that covering its junction and the ends of both thermoelectric elements, it includes a sleeve (25) of a material that is a good conductor of heat, optionally with interposed insulation (26) between the sleeve and the elements in order to avoid short circuiting the junction if the material is also a good conductor of electricity.

12. A method of simultaneous fabricating a plurality of Peltier effect modules, characterized in that it consists in assembling face-to-face two blocks (1, 2) of semiconductor material substantially in the form of rectangular parallelepipeds, preferably one block being of N type (2) and the other being of P type (1), and in cutting up the resulting assembly perpendicularly to its assembly faces to form bars each constituted by a stack of two small blocks or elements, preferably an N type element (2n) and a P type element (1n) which are bonded together in line with each other.

13. A method according to claim 12, characterized by the fact that the two blocks (1, 2) are assembled together by adhesive or by other bonding.

14. A method according to claim 12 or 13, characterized in that cutting takes place initially in a first series of mutually parallel planes, and then in a second series of planes that are mutually parallel and perpendicular to the planes of the first series.

15. A method according to any one of claims 12 to 14, characterized in that prior to performing the cutting operations, a plate of conductive material (5, 6) e.g. copper is bonded or stuck to the face of each block (1, 2) that is opposite from its face (3, 4) for being bonded to the other block.

16. A method according to claim 15, characterized in that two plates of conductive material (5, 6) having different thicknesses are used.

17. A method of collectively installing sleeves on the modules according to claim 11, characterized by the fact that once those portions of the modules other than their ends in the vicinity of the junctions have been masked by two facing masks (28, 29) constituted by blocks provided with a plurality of parallel holes (30) in which said modules (31) are engaged via their ends remote from the junctions, metal vapor is deposited on the modules in a vacuum.
